# EUROPÄISCHE PATENTANMELDUNG

(11) **EP 3 373 452 A1**
(43) Veröffentlichungstag der Anmeldung: **12.09.2018**
(21) Anmeldenummer: 17160012.5
(22) Anmeldetag: 09.03.2017
(51) Int. Cl.: H03K 17/732, H02M 1/06

(54) **GLEICHSPANNUNGSSCHALTER MIT MITTELN ZUR ERZEUGUNG EINES GEGENSTOMS**

(71) Anmelder: Siemens Aktiengesellschaft, 80333 München (DE)
(72) Erfinder: Rupp, Jürgen, 91056 Erlangen (DE)

(57) **Zusammenfassung**

Die Erfindung betriff einen Gleichspannungsschalter (10) mit zwei Anschlussklemmen (11, 12), zwischen denen sich ein Betriebsstrompfad mit einem Thyristorschalter (13) mit zumindest einem Thyristor (14) erstreckt und mit Mitteln zur Erzeugung eines Gegenstroms zu dem Strom im Betriebspfad. Die Mittel umfassen dabei einen Transformator (15), dessen primärseitige Wicklung (16) parallel zu den Anschlussklemmen geschaltet ist sowie einen Pulsgenerator (18), der mit der sekundärseitigen Wicklung (17) des Transformators (15) verschaltet ist.

## Beschreibung

Die Erfindung betrifft einen Gleichspannungsschalter mit zwei Anschlussklemmen, zwischen denen sich ein Betriebsstrompfad mit einem Thyristorschalter mit zumindest einem Thyristor erstreckt und mit Mitteln zur Erzeugung eines Gegenstroms zu der Spannung im Betriebspfad.

Das Abschalten eines Gleichstroms (DC-Strom) ist wegen fehlendem Nulldurchgang schwieriger als das Abschalten eines Wechselstroms (AC-Strom). Während der Lichtbogen, der beim Öffnen der Kontakte eines mechanischen Schalters entsteht, beim AC-Strom bei geeigneter Auslegung im nächsten Stromnulldurchgang verlischt, brennt er beim DC-Strom auch über größere Abstände bis zur Zerstörung des mechanischen Schalters weiter.

Es sind verschiedene Konzepte bekannt, eine sichere Abschaltung eines DC-Stroms zu bewirken. Ein solches Konzept beruht darauf, dass ein Gegenstrom erzeugt wird, der den Laststrom kompensiert, sodass der Strom in einem mechanischen Schalter einen Nulldurchgang erfährt. Der Schalter kann dann stromlos geöffnet werden, sodass ein Lichtbogen nicht entsteht oder verlischt. Bei einem weiteren Konzept kommutiert der Strom zunächst in einen Halbleiterschalter, von dem er lichtbogenlos abgeschaltet werden kann.

Aufgabe der vorliegenden Erfindung ist es, einen Gleichspannungsschalter anzugeben, die eine verbesserte Schaltgeschwindigkeit aufweist.

Diese Aufgabe wird durch einen Gleichspannungsschalter mit den Merkmalen von Anspruch 1 gelöst. Vorteilhafte Ausgestaltungen ergeben sich aus den abhängigen Ansprüchen.

Es wird ein Gleichspannungsschalter mit zwei Anschlussklemmen vorgeschlagen, zwischen denen sich ein Betriebsstrompfad mit einem Thyristorschalter mit zumindest einem Thyristor erstreckt. Der Gleichspannungsschalter umfasst Mittel zur Erzeugung eines Gegenstroms zu der Spannung im Betriebspfad. Diese Mittel umfassen einen Transformator, dessen primärseitige Wicklung parallel zu den Anschlussklemmen geschaltet ist. Die Mittel umfassen ferner einen Pulsgenerator, der mit der sekundärseitigen Wicklung des Transformators verschaltet ist.

Vorteilhaft wird bei dem erfindungsgemäßen Gleichspannungsschalter durch den Pulsgenerator ein Gegenstrom zu dem Laststrom erzeugt, wodurch der Thyristorschalter verlischt. Durch die galvanische Trennung des Transformators kann das Potenzial auf der Sekundärseite frei gewählt werden und je nach Übersetzungsverhältnis auch die treibende Spannung. Der Gleichspannungsschalter dieser Ausprägung ermöglicht die Verwendung von Thyristoren, die kostengünstig sind und eine hohe Überlastbarkeit, z.B. bei einem Kurzschluss, aufweisen. Durch das Fehlen eines mechanischen Schalters, wie dieser bei vielen, aus dem Stand der Technik bekannten, Anwendungen eingesetzt wird, kann ein Strom schneller abgeschaltet werden. Insbesondere ist dadurch eine bessere Begrenzung eines Kurzschlussstroms im Fall eines Kurzschlusses möglich.

Eine mit der lastseitigen Anschlussklemme verschaltete Induktivität stellt dabei durch ihre Dimensionierung sicher, dass der in der primärseitigen Spule induzierte Strom in Richtung des zu löschenden Thyristors gelenkt wird und dadurch in entgegengesetzte Richtung zu dem Laststrom fließt. Ist die Leitung zwischen der lastseitigen Anschlussklemme und der Last lang genug, kann die verschaltete Induktivität als Bauelement entfallen, da die Eigeninduktivität der Leitung denselben Zweck erfüllt.

Eine zweckmäßige Ausgestaltung sieht vor, dass die primärseitige Wicklung in Serie zu einem Kondensator verschaltet ist, wobei die Serienschaltung aus der primärseitigen Wicklung und dem Kondensator zwischen den zwei Anschlussklemmen verschaltet ist. Im sperrenden Fall des Gleichspannungsschalters, genauer des Thyristorschalters, sorgt der seriell zu der primärseitigen Wicklung verschaltete Kondensator für eine Auftrennung im Pfad der primärseitigen Wicklung für DC-Ströme. Hierdurch ist sichergestellt, dass bei sperrend geschaltetem Thyristorschalter der Laststrom nicht über den parallelen Pfad mit der primärseitigen Wicklung fließen kann.

Gemäß einer weiteren zweckmäßigen Ausgestaltung ist der Pulsgenerator dazu ausgebildet, einen Spannungspuls von mehr als 10 µs und weniger als 30 µs zu erzeugen. Durch den Spannungspuls wird in der primärseitigen Wicklung ein Strom induziert, der zu dem Laststrom entgegengesetzt gerichtet ist. Die Zeitdauer des Strompulses durch den Pulsgenerator ist derart gewählt, dass dieser lang genug ist, dass der Strom durch den Thyristor des Thyristorschalters erlöschen kann.

Gemäß einer weiteren zweckmäßigen Ausgestaltung kann der Pulsgenerator eine Spannungsquelle und ein zu der Spannungsquelle in Serie geschaltetes Schaltelement umfassen. Die Spannungsquelle kann z.B. ein weiterer Kondensator sein, der mit einer Einrichtung zum Laden des Kondensators verschaltet ist. Die Spannungsquelle kann als separate Vorrichtung, beispielsweise als der separate Kondensator, vorgesehen sein, die unabhängig von anderen Komponenten des Gleichspannungsnetzwerks an den Transformator angeschlossen ist. Dadurch kann eine Bereitschaft der Spannungsquelle unabhängig von sonstigen Gegebenheiten sichergestellt werden, beispielsweise durch eine eigene Aufladeschaltung für die Spannungsquelle. Die Spannungsquelle kann auch Teil einer weiteren Schaltung sein, die anderweitig mit dem Gleichspannungsnetzwerk in Beziehung steht. Hierdurch werden vorhandene Ressourcen des Aufbaus erneut verwendet und somit kann eine Einsparung an Komponenten erzielt werden.

Eine weitere zweckmäßige Ausgestaltung sieht vor, dass mit einer lastseitigen Anschlussklemme der zwei Anschlussklemmen eine Freilaufdiode verschaltet ist. Durch das Vorsehen der Freilaufdiode wird sichergestellt, dass bei einem schnellen Abschalten des Stroms im Betriebsstrompfad mit Hilfe des Gleichspannungsschalters der Betriebsstrom im lastseitigen Teil des Gleichspannungsnetzwerks aufgrund dort vorhandener Induktivitäten über die Freilaufdiode weiter fließen kann bis die darin gespeicherte Energie abgebaut ist. Dies ist beispielsweise beim Auftreten eines Kurzschlusses zweckmäßig.

Eine weitere zweckmäßige Ausgestaltung sieht vor, dass mit einer lastseitigen Anschlussklemme der zwei Anschlussklemmen ein Pufferkondensator verschaltet ist. Durch den Pufferkondensator kann in dem Fall, in dem der Laststrom kleiner als ein Haltestrom durch den Thyristorschalter ist, sichergestellt werden, dass eine Last temporär aus dem Pufferkondensator mit Strom versorgt wird. Hierzu steht der Pufferkondensator beispielsweise anderweitig mit dem Gleichspannungsnetzwerk in Beziehung, um vorher auf seine Betriebsspannung aufgeladen zu sein.

Eine weitere zweckmäßige Ausgestaltung sieht vor, dass mit einer quellseitigen Anschlussklemme der zwei Anschlussklemmen ein Mittel zur Spannungsbegrenzung verschaltet ist. Alternativ kann ein Mittel zur Spannungsbegrenzung zwischen den zwei Anschlussklemmen verschaltet sein. Das Mittel zur Spannungsbegrenzung dient dazu, beim Abschalten des Thyristorschalters eine sich aufgrund einer vorhandenen quellseitigen Induktivität aufbauende Spannung abzubauen bzw. in ihrer Höhe zu begrenzen.

Das Mittel zur Spannungsbegrenzung kann einen Varistor, ein RC-Glied oder einen Bremschopper umfassen.

Umfasst der Thyristorschalter einen einzigen Thyristor, so ist der Gleichspannungsschalter als unidirektionaler Gleichspannungsschalter ausgebildet, der lediglich einen Stromfluss von seiner quellseitigen Anschlussklemme zu seiner lastseitigen Anschlussklemme handhaben kann. In einer alternativen Ausgestaltung kann der Thyristorschalter zwei antiparallel verschaltete Thyristoren oder einen Triac umfassen, wodurch der erfindungsgemäße Gleichspannungsschalter unabhängig von der Stromflussrichtung eingesetzt werden kann. Ein zwei Thyristoren umfassender Thyristorschalter ist in der Lage einen Stromfluss unabhängig von dessen Richtung abzuschalten.

Die Erfindung wird nachfolgend näher anhand von Ausführungsbeispielen beschrieben. Es zeigen:
- Fig. 1: einen erfindungsgemäßen unidirektionalen Gleichspannungsschalter, und
- Fig. 2: eine schematische Darstellung eines erfindungsgemäßen bidirektionalen Gleichspannungsschalters.

In den Figuren sind gleiche Elemente mit gleichen Bezugszeichen versehen. Die einzelnen Merkmale und Elemente sind lediglich schematisiert dargestellt.

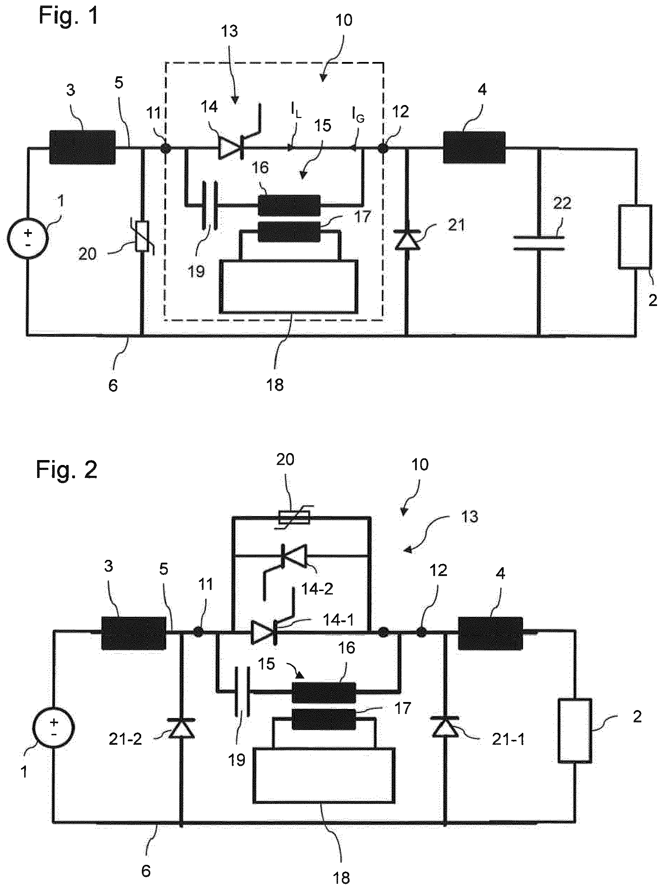

Fig. 1 zeigt ein erstes Ausführungsbeispiel eines erfindungsgemäßen Gleichspannungsschalters 10, der als unidirektionaler Schalter ausgebildet ist. Dies bedeutet, der Gleichspannungsschalter 12 ist dazu gestaltet, einen Stromfluss von einer Gleichspannungsquelle zu einer Last in einer Richtung zu schalten. Das Gleichspannungsnetzwerk wird aus einer mit 1 bezeichneten Gleichspannungsquelle gespeist und somit mit einer Gleichspannung versorgt.

Bei dem Gleichspannungsnetzwerk kann es sich um ein Netzwerk in der HGÜ-Stromversorgung handeln oder beispielsweise um ein Netzwerk in einem Fahrzeug, beispielsweise eine Lokomotive oder einen Triebwagen oder im Bereich der Einspeisung um ein Netzwerk für elektrisch betriebene Fahrzeuge. Bei der Gleichspannungsquelle kann es sich darüber hinaus um eine Energieerzeugungseinheit, z.B. eine Photovoltaikanlage, ein Speichersystem, ein Batterieladegerät, eine Windenergieanlage, einen Gleichrichter und dergleichen handeln. Bei der Last 2 kann es sich beispielsweise um einen Antrieb eines Gleichspannungsnetzes oder ähnliches handeln. Grundsätzlich ist das Prinzip auf allen Spannungsebenen von Niederspannung über Mittelspannung bis zu Hochspannung anwendbar.

Zwischen einer Last 2, die stark vereinfachend durch einen Widerstand symbolisiert ist, und der Gleichspannungsquelle 1 ist der bereits erwähnte Gleichspannungsschalter 10 angeordnet. Der Gleichspannungsschalter 10 ist dabei mit zwei Anschlussklemmen 11, 12 seriell in einen ersten Pol 5 des Gleichspannungsnetzwerks eingebunden.

Zwischen den Anschlussquellen 11, 12 weist der Gleichspannungsschalter 10 einen Thyristorschalter 13 auf, der im Betriebspfad des Gleichspannungsschalters 10 liegt. Der Thyristorschalter 13 umfasst im vorliegenden Ausführungsbeispiel des unidirektionalen Gleichspannungsschalters einen einzigen Thyristor 14, dessen Anode mit der Anschlussklemme 11 und dessen Kathode mit der Anschlussklemme 12 verschaltet ist.

Eine Serienschaltung aus einer primärseitigen Wicklung 16 eines Transformators 15 und eines Kondensators 19 ist parallel zu dem Betriebsstrompfad zwischen den Anschlussklemmen 11, 12 verschaltet. Eine sekundärseitige Wicklung 17 des Transformators 15 ist in Serie mit einem Pulsgenerator 18 geschaltet.

Der Pulsgenerator 18 ist dazu ausgebildet, mittels geeigneter Ansteuerung einen Spannungspuls zu erzeugen. Der Spannungspuls weist beispielsweise eine Zeitdauer von mehr als 10 µs und weniger als 30µs auf. Durch den von dem Pulsgenerator 18 erzeugten Spannungspuls fließt durch die sekundärseitige Wicklung 17 ein Strom, welcher durch die Kopplung mit der primärseitigen Wicklung 16 einen Strom I_{G} (nachfolgend als Gegenstrom bezeichnet) induziert, der eine zu dem Laststrom I_{L} in dem Betriebsstrompfad in entgegengesetzte Richtung aufweist. Die Höhe des Gegenstroms I_{G} wird durch geeignete Dimensionierung des Transformators 15 derart bemessen, dass in dem Betriebsstrompfad für die Zeitdauer des von dem Pulsgenerator 18 erzeugten Spannungspulses sich ein Strom von Null ergibt. Da damit auch der Haltestrom des Thyristors 14 unterschritten wird, erfolgt ein Löschen des Thyristors 14, wodurch der Gleichspannungsschalter sperrend geschaltet ist.

Durch den Kondensator 19 ist im sperrenden Zustand des Thyristors 14 sichergestellt, dass ausgehend von der Gleichspannungsquelle 1 kein Strom über die primärseitige Wicklung 16 in Richtung der Last 2, oder umgekehrt, fließen kann.

Der Pulsgenerator 18 kann z.B. eine Spannungsquelle und ein zu der Spannungsquelle in Serie geschaltetes Schaltelement umfassen, um durch Einschalten des Schaltelements den Spannungspuls zu erzeugen. Die Spannungsquelle kann als Kondensator ausgebildet sein, die mit einer Einrichtung zum Laden des Kondensators verschaltet ist. Die Spannungsquelle und die Einrichtung zum Laden des Kondensators können von dem Gleichspannungsnetz separate Komponenten sein, um eine Funktionsfähigkeit auch bei einem Fehler in dem Gleichspannungsnetzwerk sicherzustellen. Die Spannungsquelle kann auch Teil einer weiteren Schaltung sein, die anderweitig mit dem Gleichspannungsnetzwerk in Beziehung steht. Hierdurch können vorhandene Ressourcen des Gleichspannungsnetzwerks erneut verwendet werden, wodurch eine Einsparung von Komponenten erzielt ist.

Beim Abschalten des durch den Betriebsstrompfad fließenden Laststroms I_{L} können aufgrund von quell- und lastseitigen Induktivitäten 3, 4, die entweder reale Bauelemente oder ausreichend große Leitungsinduktivitäten sind, Spannungsspitzen entstehen. Um solche unerwünschten Spannungen zu vermeiden, ist zwischen der lastseitigen Anschlussklemme 12 des ersten Pols 5 des Gleichspannungsnetzwerks und einem zweiten Pol 6 des Gleichspannungsnetzwerks eine Freilaufdiode 21 verschaltet. Ein Anodenanschluss der Freilaufdiode 21 ist dabei mit dem zweiten Pol 6, ein Kathodenanschluss mit dem ersten Pol 5, d.h. der lastseitigen Anschlussklemme 12 verschaltet. Im Falle eines, z.B. lastseitigen Kurzschlusses, kann nach dem Auftrennen des Betriebsstrompfades im erfindungsgemäßen Gleichspannungsschalters ein Strom über die Freilaufdiode 21, die lastseitige Induktivität 4 und die Last 2 fließen, wodurch eine Überspannung abgebaut wird.

Zwischen der quellseitigen Anschlussklemme 11 und dem Seitenpol 6 ist ein Mittel 20 zur Spannungsbegrenzung vorgesehen. Im Ausführungsbeispiel ist das Mittel 20 zur Spannungsbegrenzung als Varistor ausgebildet. Anstelle der Verwendung eines Varistors könnte auch ein RC-Glied oder ein Bremschopper zum Einsatz gelangen. Mit Hilfe des Mittels 20 zur Spannungsbegrenzung wird beim Auftrennen des Betriebsstrompfades mit Hilfe des Gleichspannungsschalters eine Spannung der quellseitigen Induktivität 3 abgebaut bzw. in ihrer Höhe begrenzt.

Das Mittel 20 zur Spannungsbegrenzung 20 sowie die Freilaufdiode 21, die lediglich optionale Elemente sind, können Bestandteil des Gleichspannungsschalters oder von diesem getrennte Komponenten sein.

In dem elektrischen Ersatzschaltbild des Gleichspannungsnetzwerks ist ferner ein Pufferkondensator 22, welcher parallel zu der Last 2 und mit dem von der Anschlussklemme verschaltet ist, vorgesehen. Der Pufferkondensator 22 dient zur Pufferung eines Stroms, wenn der Laststrom kleiner als der Haltestrom des Thyristorschalters 13 des Gleichspannungsschalters wird. Dadurch wird die Last 2 zunächst aus dem Pufferkondensator 22 versorgt bis der Thyristorschalter 13 wieder leitend geschaltet ist. Ohne den optional vorgesehenen Pufferkondensator würde andernfalls die über der Last 2 anfallende Spannung kurzzeitig bis zur nächsten Zündung des Thyristorschalters 13 zusammenbrechen.

Der vorgeschlagene Gleichspannungsschalter 10 weist gegenüber einem mechanischen Schaltelement den Vorteil auf, dass die Zeitdauer bis zum Auftrennen des Betriebsstrompfades wesentlich kürzer ist. Während der Thyristor zwischen 10 µs und 30 µs benötigt, um den Betriebsstrompfad aufzutrennen, sind bei einem Auftrennvorgang mit einem mechanischen Schalter typischerweise mehrere ms erforderlich.

Fig. 2 zeigt ein zweites Ausführungsbeispiel eines erfindungsgemäßen Gleichspannungsschalters 10, welcher eine bidirektionale Führung des Stroms im Betriebsstrompfad erlaubt. Zu diesem Zweck umfasst der Thyristorschalter 13 zwei antiparallel geschaltete Thyristoren 14-1, 14-2. Die Parallelschaltung der antiparallel verschalteten Thyristoren 14-1, 14-2 ist zwischen den zwei Anschlussklemmen 11, 12 verschaltet. Der Thyristorschalter 13 könnte anstelle zweier antiparallel verschalteter Thyristoren 14-1, 14-2 auch einen Triac umfassen. Parallel zu dem Thyristorschalter 13 ist in diesem Ausführungsbeispiel das Mittel 20 zur Spannungsbegrenzung vorgesehen. Lediglich beispielhaft ist diese wiederum als Varistor ausgebildet.

Das Mittel zur Erzeugung eines Gegenstroms ist wie in Fig. 1 beschrieben ausgebildet.

Der Varistor 20 ist dazu ausgebildet, beim Abschalten des Stroms durch den Betriebsstrompfad mit Hilfe des Mittels zur Erzeugung des Gegenstroms die Spannung quellseitig zu limitieren. Um eine ausgangsseitige Spannungsüberhöhung zu begrenzen, sind nunmehr sowohl mit der Anschlussklemme 11 als auch mit der Anschlussklemme 12 jeweils eine Freilaufdiode 21-1 und 21-2 verbunden. Die Freilaufdiode 21-1, die zwischen der Anschlussklemme 12 und dem zweiten Pol 6 des Gleichspannungsnetzwerks verschaltet ist, dient dabei dazu, den Laststrom zu begrenzen, wenn dieser, wie in Fig. 2 gezeigt, von der links angeordneten Gleichspannungsquelle 1 zu der rechts angeordneten Last 2 fließt. Werden die Gleichspannungsquelle 1 und die Last 2 in dem Gleichspannungsnetzwerk vertauscht, d.h. ist die Gleichspannungsquelle 1 auf der rechten Seite des Gleichspannungsschalters 10 angeordnet und die Last 2 auf der linken Seite des Gleichspannungsschalters 10, so dient die Freilaufdiode 21-2 zur Begrenzung einer Überspannung im lastseitigen Teil des Netzwerks.

Bei der bidirektionalen Ausführung des Gleichspannungsschalters 10 gemäß Fig. 2 ist der Pulsgenerator 18 dazu ausgebildet, eine Richtung des Spannungspulses abhängig davon zu erzeugen, welcher der beiden Thyristoren 14-1, 14-2 abgeschaltet werden soll. Durch die Richtung des Spannungspulses kann somit sichergestellt werden, dass der Gegenstrom I_{G} in der für den gerade aktiven Thyristor 14-1 oder 14-2 "richtigen" Richtung erzeugt wird.

Die in den Ersatzschaltbildern dargestellten lastseitigen Induktivitäten 4 in den Ausführungsbeispielen gemäß den Fig. 1 und 2 sind, sofern die Induktivitäten im Lastpfad, z.B. aufgrund langer Kabel nicht ausreichend groß sind, als reale Bauelemente vorgesehen. Durch die Dimensionierung der lastseitigen Induktivitäten 4 in der Relation zu der primärseitigen Wicklung 16 des Transformators 15 wird sichergestellt, dass die Impedanz in dem Kreis, der durch die primärseitige Wicklung 16 und den Thyristor 14 (bzw. den zu löschenden Thyristor 14-1 oder 14-2) gebildet ist, kleiner ist als die Impedanz in einem über die lastseitige Induktivität 4 fließenden Pfad. Dadurch wird sichergestellt, dass der durch das Mittel zur Erzeugung eines Gegenstroms zu erzeugende Strom I_{G} in entgegengesetzter Richtung zu dem Laststrom I_{L} in dem Betriebsstrompfad fließt und den Betriebsstrom diesen zu Null macht, so dass der Thyristor verlöschen kann.

Damit sichergestellt werden kann, dass der Gegenstrom I_{G} sicher in der entgegengesetzten Richtung zu dem Laststrom I_{L} getrieben wird, und der zu sperrende Thyristor verlischt, ist es zweckmäßig, wenn die durch den Pulsgenerator erzeugte Spannung größer oder zumindest gleich der von der Gleichspannungsquelle 1 gelieferten Spannung ist. Es versteht sich, dass diese Relation abhängig ist von der Speisespannung des Pulsgenerators und dem Wicklungsverhältnis zwischen primärseitiger und sekundärseitiger Wicklung des Kondensators.

## Patentansprüche

1. Gleichspannungsschalter (10) mit zwei Anschlussklemmen (11, 12), zwischen denen sich ein Betriebsstrompfad mit einem Thyristorschalter (13) mit zumindest einem Thyristor (14) erstreckt und mit Mitteln zur Erzeugung eines Gegenstroms zu dem Strom im Betriebspfad, wobei die Mittel umfassen:
- einen Transformator (15), dessen primärseitige Wicklung (16) parallel zu den Anschlussklemmen geschaltet ist;
- einen Pulsgenerator (18), der mit der sekundärseitigen Wicklung (17) des Transformators (15) verschaltet ist.

2. Gleichspannungsschalter nach Anspruch 1,
**dadurch gekennzeichnet, dass** die primärseitige Wicklung (16) in Serie zu einem Kondensator (19) verschaltet ist, wobei die Serienschaltung aus der primärseitigen Wicklung (16) und dem Kondensator (19) zwischen den zwei Anschlussklemmen (11, 12) verschaltet ist.

3. Gleichspannungsschalter nach Anspruch 1 oder 2,
**dadurch gekennzeichnet, dass** der Pulsgenerator (18) dazu ausgebildet ist, einen Spannungspuls von mehr als 10 µs und weniger als 30 µs zu erzeugen.

4. Gleichspannungsschalter nach Anspruch 3,
**dadurch gekennzeichnet, dass** der Pulsgenerator (18) eine Spannungsquelle und einen zu der Spannungsquelle in Serie geschaltetes Schaltelement umfasst.

5. Gleichspannungsschalter nach Anspruch 4,
**dadurch gekennzeichnet, dass** die Spannungsquelle ein weiterer Kondensator ist, der mit einer Einrichtung zum Laden des Kondensators verschaltet ist.

6. Gleichspannungsschalter nach einem der vorhergehenden Ansprüche,
**dadurch gekennzeichnet, dass** mit einer lastseitigen Anschlussklemme (12) der zwei Anschlussklemmen (11, 12) eine Freilaufdiode (21) verschaltet ist.

7. Gleichspannungsschalter nach einem der vorhergehenden Ansprüche,
**dadurch gekennzeichnet, dass** mit einer lastseitigen Anschlussklemme (12) der zwei Anschlussklemmen (11, 12) ein Pufferkondensator (22) verschaltet ist.

8. Gleichspannungsschalter nach einem der Ansprüche 1 bis 7, **dadurch gekennzeichnet, dass** mit einer quellseitigen Anschlussklemme (11) der zwei Anschlussklemmen (11, 12) ein Mittel (20) zur Spannungsbegrenzung verschaltet ist.

9. Gleichspannungsschalter nach einem der Ansprüche 1 bis 7, **dadurch gekennzeichnet, dass** ein Mittel (20) zur Spannungsbegrenzung zwischen den zwei Anschlussklemmen (11, 12) verschaltet ist.

10. Gleichspannungsschalter nach Anspruch 8 oder 9,
**dadurch gekennzeichnet, dass** das Mittel (20) zur Spannungsbegrenzung einen Varistor oder ein RC-Glied oder einen Bremschopper umfasst.

11. Gleichspannungsschalter nach einem der Ansprüche 1 bis 10,
**dadurch gekennzeichnet, dass** der der Thyristorschalter (13) einen Thyristor (14) umfasst.

12. Gleichspannungsschalter nach einem der Ansprüche 1 bis 10,
**dadurch gekennzeichnet, dass** der der Thyristorschalter (13) zwei antiparallel verschaltete Thyristoren (14-1, 14-2) oder einen Triac umfasst.
